# EUROPEAN PATENT SPECIFICATION

(11) **EP 3 073 524 B1**
(45) Date of publication and mention of the grant of the patent: **04.11.2020**
(21) Application number: 16157009.8
(22) Date of filing: 23.02.2016
(51) Int. Cl.: H01L 23/373, H01L 23/42, H01L 23/427, H01L 25/07, H05K 7/20, H01L 23/473

(54) **HIGH THERMAL CONDUCTIVITY JOINT UTILIZING CONTINUOUS ALIGNED CARBON NANOTUBES**
VERBINDUNG MIT HOHER WÄRMELEITFÄHIGKEIT UNTER VERWENDUNG VON KONTINUIERLICHEN AUSGERICHTETEN KOHLENSTOFFNANORÖHREN
JOINT DE CONDUCTIVITÉ THERMIQUE ÉLEVÉE UTILISANT DES NANOTUBES DE CARBONE ALIGNÉS EN CONTINU

(30) Priority: 23.03.2015 US 201514666254
(43) Date of publication of application: 28.09.2016
(73) Proprietor: The Boeing Company, Chicago, IL 60606-1596 (US)
(72) Inventor: TOMZYNSKA, Anna Maria, Chicago, IL 60606-1596 (US); ASTON, Richard William, Chicago, IL 60606-1596 (US)
(74) Representative: Boult Wade Tennant LLP

(56) References cited:
- US-A1- 2006 234 056
- US-A1- 2007 004 081
- US-A1- 2008 081 176
- US-A1- 2009 129 011
- US-A1- 2011 012 252

## Description

### BACKGROUND

### 1. Field

Various embodiments are related to spacecraft radiator panels and, more particularly, to radiator panels utilizing heat-pipes.

### 2. Related Art

Spacecraft include a plethora of equipment, such as electronic equipment, that generates heat. This heat must be dissipated, and because space is essentially void of air, the heat must be radiated to outer space. Spacecraft, such as satellites, typically include radiator panels that draw the heat from electronics and other equipment to an outer surface of the spacecraft.

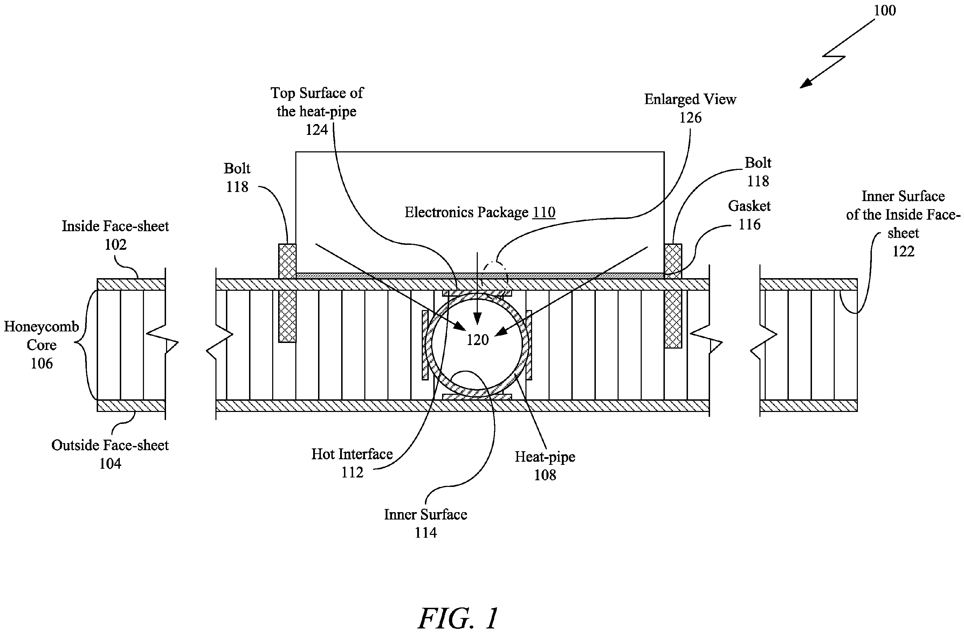

In FIG. 1, a front-view of a schematic diagram of an example of a typical known radiator panel 100 is shown. The radiator panel 100 may include an inside face-sheet 102 that faces the inside of the spacecraft, an outside face-sheet 104 that faces the outside of the spacecraft towards outer space, a honeycomb core 106 positioned between the inside and outside face-sheets 102 and 104 to give the radiator panel 100 structural support, and one or more heat-pipes 108 positioned between the inner and outside face-sheets 102 and 104 to transfer the heat generated by an electronics package 110 away from the electronics package 100 to the outside face-sheet 104 and ultimately to outer space. In general, heat-pipes (such as heat-pipe 108) are heat transfer devices that combine the principles of both thermal conductivity and phase transition of a working fluid to transfer heat from one location to another, such as from an electronic device to a heat sink, or in the application of a spacecraft, ultimately to outer space. In an example of operation of the heat-pipe 108, at the hot interface 112 of the heat-pipe 108 a fluid (such as a liquid) in contact with the thermally conductive solid surface of the hot interface 112 turns into a vapor by absorbing heat from that surface of the hot interface 112. The vapor then travels along the heat-pipe 108 to a cold interface (not shown) and condenses back into a liquid - releasing the latent heat in the process. The liquid then returns to the hot interface 112 through capillary action, centrifugal force, or gravity, and the process cycle repeats. In this example, the heat-pipe 108 may include grooved wicks (not shown) along an inner surface 114 and the axial length of the heat-pipe 108. In general, the grooved wicks are utilized in spacecraft, instead of the screen or sintered wicks used for terrestrial heat-pipes, since the heat-pipe 108 does not have to operate against gravity in outer space. This allows the spacecraft heat-pipe 108 to be several meters long, in contrast to the roughly 25 cm of maximum length for a water heat-pipe operating on Earth. In spacecraft applications, typically ammonia is the most common working fluid for spacecraft heat-pipes. Ethane may also be utilized when the heat-pipe 108 operate at temperatures below the ammonia freezing temperature. In this example, the heat flow 120 from the electronics package 110 to the heat-pipe 108 is shown.

In this example, the electronics package 110 is shown attached to the top of the inside face-sheet 102 via a gasket 116 and two mechanical attachments devices 118 that may be bolts. Alternately, instead of a gasket 116 a layer of room-temperature vulcanizing ("RTV") silicone sealer may be utilized.

Unfortunately in this example, there is usually a thermal choke between the inner surface 122 of the inside face-sheet 102 and the top surface 124 of the heat-pipe 108 caused by an interface impedance the results from the interface of these different elements. As such, there is an inefficient thermal transfer from electronics package 110 to the heat-pipe 108. To better describe the problem, a cross-sectional view of an enlarged view 126 of a portion of the radiator panel 100 along a cutting plane looking into the front of the radiator panel 100, which is perpendicular to heat-pipe 108, is shown.

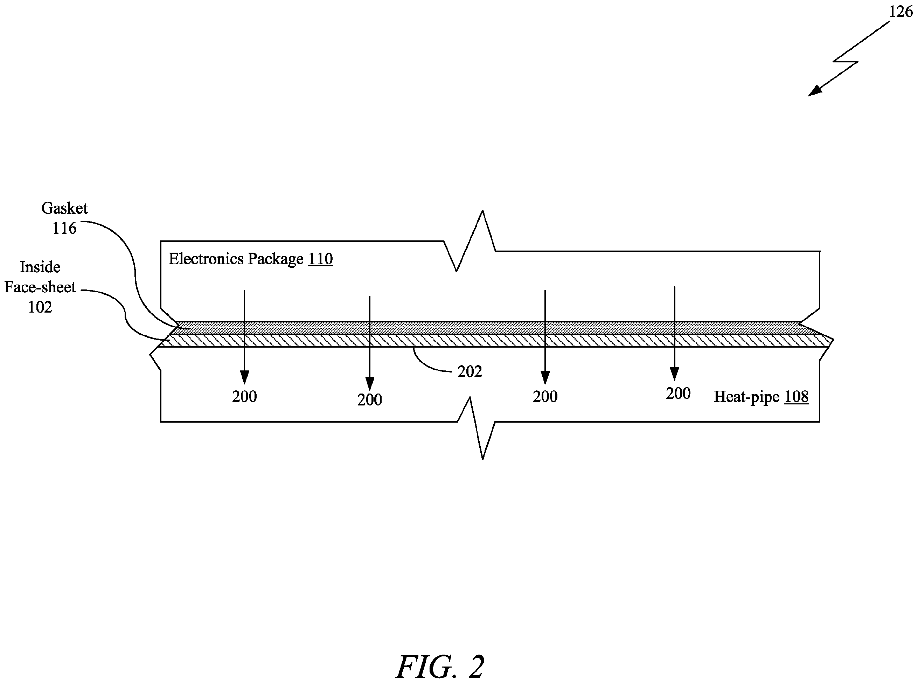

In FIG. 2, a block diagram of an example of an implementation of the enlarged portion 126 of the radiator panel (of 100 FIG. 1) is shown. As before, the enlarged portion 126 includes the portions of the inside face-sheet 102, heat-pipe 108, electronics package 110, and the gasket 116. In this example, a thermal choke on the heat flow 200 between the inside face-sheet 102 and the heat-pipe 108 because the thermal transfer characteristics of the impedance interface 202 between the face-sheet 102 and heat-pipe 108 is inefficient. As such, there is a need for new radiator panel structure that more efficiently transfers heat from the face-sheet to the heat-pipe.

US2011/0012252 discloses a power semiconductor module. The module includes metal plates each having a first through hole, with an anodic oxidation layer formed on a surface of metal plates and an interior of the first through hole. A cooling member has a second through hole at a position corresponding to the first through hole, and the metal plates are attached to both sides of the cooling member. A circuit layer is formed in the anodic oxidation layer and performs an interlayer connection through a via formed in the first and second through holes. A power device is connected to the circuit layer. A resin encapsulant encloses the circuit layer and the power device. A housing is installed to each of the metal plates to form a sealing space for the resin encapsulant.

US 2009/129011 discloses a thermal module provided for absorbing and dissipating heat from a heat generating component. The module comprises a module body, input and output ports, and a channel disposed within the module body. The module body includes a thermally conductive base, a top surface, and a side surface rising from the base toward the top surface. The base is disposable adjacent the heat generating component to facilitate transfer of heat from the heat generating component to the base. The input and output ports are each disposed on the side surface of the body. A channel is encapsulated within the module body and extends from the input port to the output port to define a flow path. The channel is operative to convey a cooling fluid therethrough for absorbing and dissipating the heat from the heat generating component.

US 2006/234056 discloses a thermal interface material that includes a matrix and a plurality of carbon nanotubes. The matrix includes a first surface and an opposite second surface. The carbon nanotubes are embedded in the matrix uniformly. The carbon nanotubes extend from the first surface to the second surface and each have two opposite ends. At least one of the two opposite ends of the carbon nanotubes is exposed out of one of the first and second surfaces of the matrix. The exposed ends of the carbon nanotubes being elastically bent/embedded in a phase change layer formed thereon.

US 2008/081176 discloses a thermal interface material that includes a macromolecular material having two opposite surfaces and a plurality of carbon nanotubes each having two opposite ends embedded in the macromolecular material. The two opposite ends of the carbon nanotubes extend out of the two opposite surfaces of the macromolecular material respectively. A method for manufacturing the thermal interface material is also provided.

US 2007/004081 discloses a method for manufacturing a thermal interface material that includes the steps of: providing a first substrate having a first surface and an opposite second substrate having an opposite second surface spaced apart a predetermined distance; forming a number of carbon nanotubes from one of the first and second surfaces; forming a composite material by filling interstices between the carbon nanotubes with a liquid state base material; curing the liquid state base material filled in the interstices between the carbon nanotubes; and removing the first and second substrates from the composite material.

US2013/0233516 discloses a radiator panel for use with high-powered unit in satellite, having a heat pipe and a honeycomb core positioned between spaced-apart face-sheets, and an external structural reinforcement unit for extending across external side of outside face-sheet.

### SUMMARY

Disclosed is a thermal conductive joint between a face-sheet and a heat-pipe on a radiator panel. The thermal conductive joint includes an adhesive layer attached between the face-sheet and the heat-pipe and a plurality of carbon nanotubes ("CNTs") within the adhesive layer.

The plurality of CNTs may be oriented in an axial direction between the face-sheet and the heat-pipe. This axial direction may be perpendicular to the surface of the face-sheet and surface of the heat-pipe. Additionally, the plurality of CNTs may be continuous between the face-sheet and the heat-pipe to a point where the CNTs may be in physical contact with the face-sheet and heat-pipe. In this example, if the face-sheet and heat-pipe are constructed of metal, the plurality of CNTs may act as a thermal bridge from the metal of face-sheet to the metal of the heat-pipe. In this case, the plurality of CNTs may act as a substantial thermal bridge through the adhesive layer. In this configuration, the plurality of CNTs may form a parallel heat conduction path from the face-sheet to the heat-pipe.

Other devices, apparatus, systems, methods, features and advantages of the disclosure will be or will become apparent to one with skill in the art upon examination of the following figures and detailed description. It is intended that all such additional systems, methods, features and advantages be included within this description, be within the scope of the disclosure, and be protected by the accompanying claims.

### BRIEF DESCRIPTION OF THE FIGURES

The disclosure may be better understood by referring to the following figures. The components in the figures are not necessarily to scale, emphasis instead being placed upon illustrating the principles of the disclosure. In the figures, like reference numerals designate corresponding parts throughout the different views.
FIG. 1 is a front-view of schematic diagram of an example of a typical radiator panel.
FIG. 2 is a cross-sectional view of an enlarged portion of the portion of the radiator panel shown in FIG. 1 along a cutting plane looking into the front of the radiator panel in accordance with various embodiments.
FIG. 3 is an exploded assembly perspective-view of an example of an implementation of a thermal conductive joint between a face-sheet and a heat-pipe embedded in a radiator panel in accordance with various embodiments.
FIG. 4 is a front view of the radiator panel shown in FIG. 3 in accordance with various embodiments.
FIG. 5 is a cross-sectional view of an enlarged portion of the portion of the first thermal conductive joint shown in FIG. 4 along a cutting plane looking into the front of the radiator panel in accordance with various embodiments.
FIG. 6 is a microscopic front-view of an example of an implementation of a bond line between the face-sheet and heat-pipe with a plurality of CNTs embedded in an adhesive layer within the bond line in accordance with various embodiments.
FIG. 7 is a cross-sectional view of an enlarged portion of the adhesive layer is shown in FIG. 8 in accordance with various embodiments.

### DETAILED DESCRIPTION

Disclosed is a thermal conductive joint between a face-sheet and a heat-pipe on a radiator panel. The thermal conductive joint includes an adhesive layer attached between the face-sheet and the heat-pipe and a plurality of carbon nanotubes ("CNTs") within the adhesive layer.

The plurality of CNTs may be oriented in an axial direction between the face-sheet and the heat-pipe. This axial direction may be perpendicular to the surface of the face-sheet and surface of the heat-pipe. Additionally, the plurality of CNTs may be continuous between the face-sheet and the heat-pipe to a point where the CNTs may be in physical contact with the face-sheet and heat-pipe. In this example, if the face-sheet and heat-pipe are constructed of metal, the plurality of CNTs may act as a thermal bridge from the metal of face-sheet to the metal of the heat-pipe. In this case, the plurality of CNTs may act as a substantial thermal bridge through the adhesive layer. In this configuration, the plurality of CNTs may form a parallel heat conduction path from the face-sheet to the heat-pipe.

For the purposes of this disclosure, CNTs are allotropes of carbon with a cylindrical nanostructure. CNTs have been constructed with length-to-diameter ratio of up to 132,000,000:1, significantly larger than for any other material. These cylindrical carbon molecules have unusual properties, which are valuable for nanotechnology, electronics, optics and other fields of materials science and technology. CNTs have very good thermal conductivity and mechanical and electrical properties.

CNTs are members of the fullerene structural family. Their name is derived from their long, hollow structure with the walls formed by one-atom-thick sheets of carbon, called graphene. These sheets are rolled at specific and discrete ("chiral") angles, and the combination of the rolling angle and radius decides the CNT's properties; for example, whether the individual nanotube shell is a metal or semiconductor. CNTs are generally categorized as single-walled nanotubes ("SWNTs") and multi-walled nanotubes ("MWNTs"). Generally, individual CNTs naturally align themselves into "ropes" held together by van der Waals forces, more specifically, pi-stacking.

Chemical bonding in CNTs is best described by applied quantum chemistry, specifically, orbital hybridization best describes chemical bonding in nanotubes. The chemical bonding of CNTs is composed entirely of *sp*² bonds, similar to those of graphite. These bonds, which are stronger than the *sp*³ bonds found in alkanes and diamond, provide CNTs with unique strength.

This unique strength makes CNTs the strongest and stiffest materials yet discovered in terms of tensile strength and elastic modulus respectively. This strength results from the covalent *sp*² bonds formed between the individual carbon atoms.

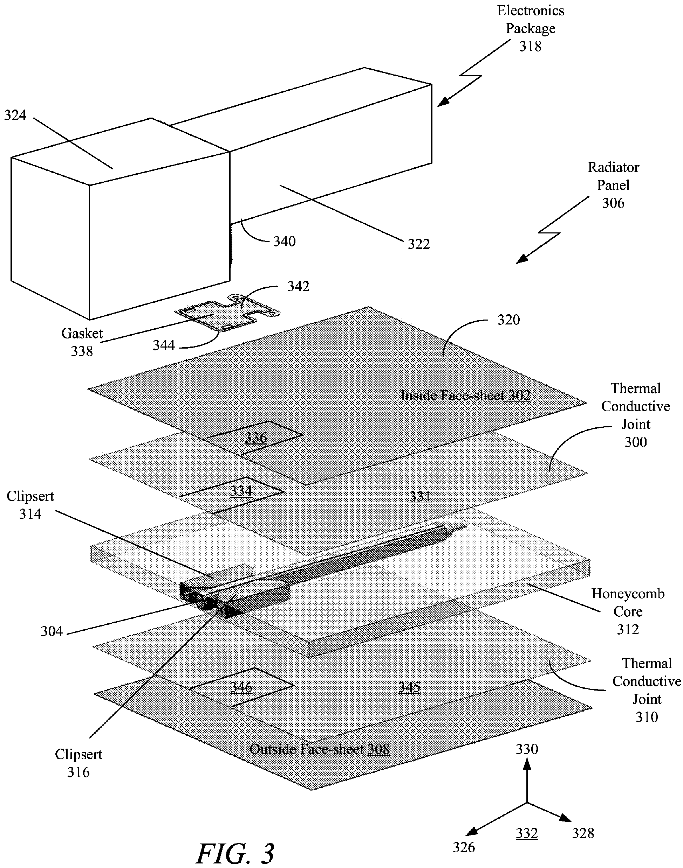

Turning to FIG. 3, an exploded assembly perspective-view of an example of an implementation of a thermal conductive joint 300 between an inside face-sheet 302 and a heat-pipe 304 embedded in a radiator panel 306 is shown in accordance with the present invention. The radiator panel 306 may also include an outside face-sheet 308 and secondary thermal conductive joint 310 between an outside face-sheet 308 and the heat-pipe 304. Moreover, the radiator panel 306 may also include a honeycomb core 312 in which the heat-pipe 304 is embedded and which is interposed between the first thermal conductive joint 300 and second thermal conductive joint 310. The honeycomb core 312 may also have a first and second clipsert 314 and 316 embedded in the honeycomb core 312 adjacent to the heat-pipe 304 and also interposed between the first thermal conductive joint 300 and second thermal conductive joint 310. In this example, the clipserts 314 and 316 are generally metallic devices that are placed under the electronics package 318 so as to allow the electronics package 318 to be bolted onto the inside face-sheet 302 via bolts (not shown). Similar to the examples shown in FIGs. 1 and 2, the radiator panel 306 may have an electronics package 318 placed on a top face 320 of the inside face-sheet 302. In this example, the electronics package 318 may include two traveling wave tube amplifiers ("TWTAs") 322 and 324.

To better understand the elements shown in FIG. 3, a reference coordinate system is shown having an *X*-axis 326, *Y*-axis 328, and *Z*-axis 330. In this example, the heat-pipe 304 and TWTAs 322 and 324 extend along the *X*-axis 326. The inner-face sheet 302, first thermal conductive joint 300, honeycomb core 312, and second thermal conductive joint 310, and outside face-sheet 308 extend outward along the *X*-axis 326 and *Y*-axis 328 parallel to an *X-Y* plane 332. When the exploded assembly of the radiator panel 306 is collapsed, the radiator panel 306 forms a sandwiched structure that has layers that are oriented in a perpendicular direction (i.e., along the *Z*-axis 326) to the *X-Y* plane 332.

In this example, the honeycomb core 312, heat-pipe 304, and clipserts 314 and 316 may be between approximately 0.5 inches to 0.625 inches in thickness. The honeycomb core 312 may be made of metal such as, for example, aluminum. The inner and outside face-sheets 302 and 308 may also be made of metal such as, for example aluminum. The first thermal conductive joint 300 is composed of a film adhesive 331 (such as an epoxy film adhesive) and includes a portion 334 of the first thermal conductivity joint 300 that has a plurality of CNTs oriented and aligned perpendicular to the bond lines (i.e., in the *Z*-axis 330) locally under a portion 336 of the inside face-sheet 302. The portion 336 of the inside face-sheet 302 corresponds to an area of the inside face-sheet 302 located under a gasket 338 that is located under an underside 340 of the first TWTA 320. The gasket 338 has a top side 342 that is placed in contact with the underside 340 of the first TWTA 320 and a bottom side 344 that corresponds to the area of the portion 336 of the inside face-sheet 302 located under a gasket 338. As such, the portion 336 of the inside face-sheet 302 corresponds to the area of the bottom side 344 of the gasket 338. Additionally, the area of the portion 336 of the inside face-sheet 302 also corresponds to an area of the portion 334 of first thermal conductive joint 300.

In this example, the second thermal conductive joint 310 may also include a film adhesive 345 (such as an epoxy film) having a portion 346 having a plurality of CNTs oriented and aligned perpendicular to the bond lines (i.e., in the Z-direction 330) locally under a portion of the outside face-sheet 308 that corresponds to the portion 334 of the inside face-sheet 302 having the CNTs. In this example, the gasket 338 may be constructed of graphite such as, for example, eGraf® graphite produced by GrafTech International Holdings Inc. of Lakewood, OH.

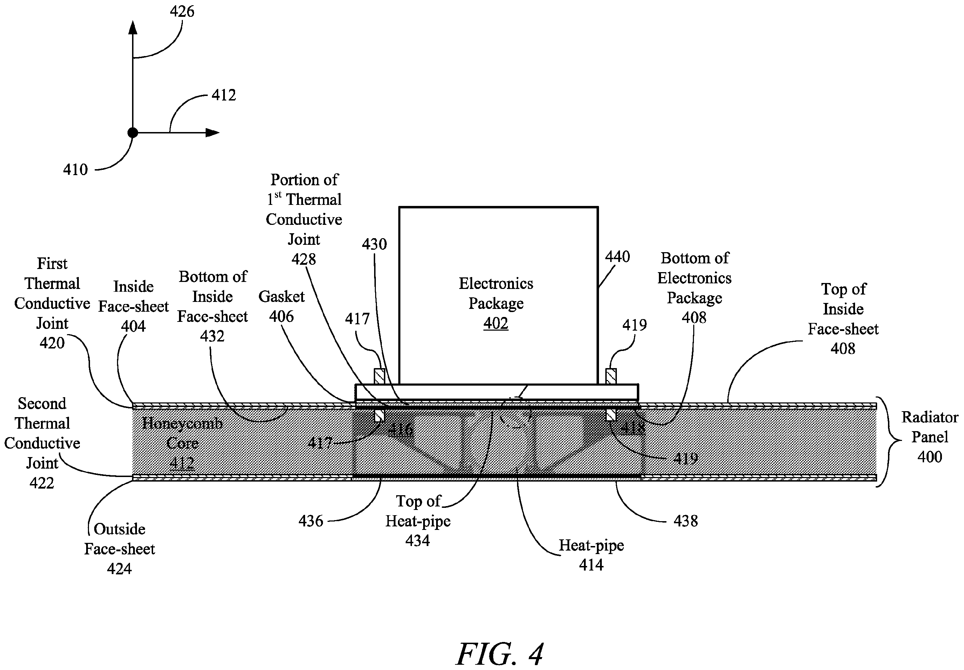

Turning to FIG. 4, a front-view of a radiator panel 400 is shown in accordance with various embodiments. In this example, an electronics package 402 (such as, for example, a TWTA) is shown placed on the inside face-sheet 404 of the radiator panel 400. A gasket 406 is shown interposed between the bottom 408 of the electronics package 402 and the top 410 of the inside face-sheet 404. The radiator panel 400 is shown to have a honeycomb core 412 and heat-pipe 414 embedded in the honeycomb core 412. Additionally embedded in the honeycomb core 412 are a first clipsert 416 and second clipsert 418, which allow the electronics package 402 to be bolted to the first and second clipserts 416 and 418 via bolts 417 and 419, respectively. The first clipsert 416, first bolt 417, second clipsert 418, and second bolt 419 may be utilized to prevent the gasket 406 from "creeping" (i.e., moving) along the interface-space between the electronics package 402 and inside face-sheet 404. In this example, the electronics package 402 may be the same as the first electronics package 320 of FIG. 3. The front-view of the radiator panel 400 is looking into the *X-*axis 410, where the inside face-sheet 404, gasket 406, honeycomb core 412 extend along the *X*-axis 410 and *Y*-axis 412 parallel to an *X-Y* plane. The radiator panel 400 forms a sandwiched structure that has layers (i.e., the inside face-sheet 404, honeycomb core 412, a first thermal conductive joint 420, second thermal conductive joint 422, and an outside face-sheet 424) that are oriented in a perpendicular direction (i.e., along a *Z-*axis 426) to the *X- Y* plane.

A portion 428 of the first thermal conductive joint 420 is shown that corresponds to an area located under a portion 430 of the inside face-sheet 404 and the gasket 406. The portion 428 of the first thermal conductive joint 420 may have a plurality of CNTs within the adhesive layer that are aligned between the bottom 432 of the inside face-sheet 404 and the top 434 of the heat-pipe 414. Similarly, a portion 436 of the second thermal conductive joint 422 is shown that corresponds to an area located under a portion 438 of the outside face-sheet 424. Both portions 436 and 438 of the second thermal conductive joint 422 and outside face-sheet 424, respectively, also correspond to the area located under the portion 430 of the inside face-sheet 404 and the gasket 406.

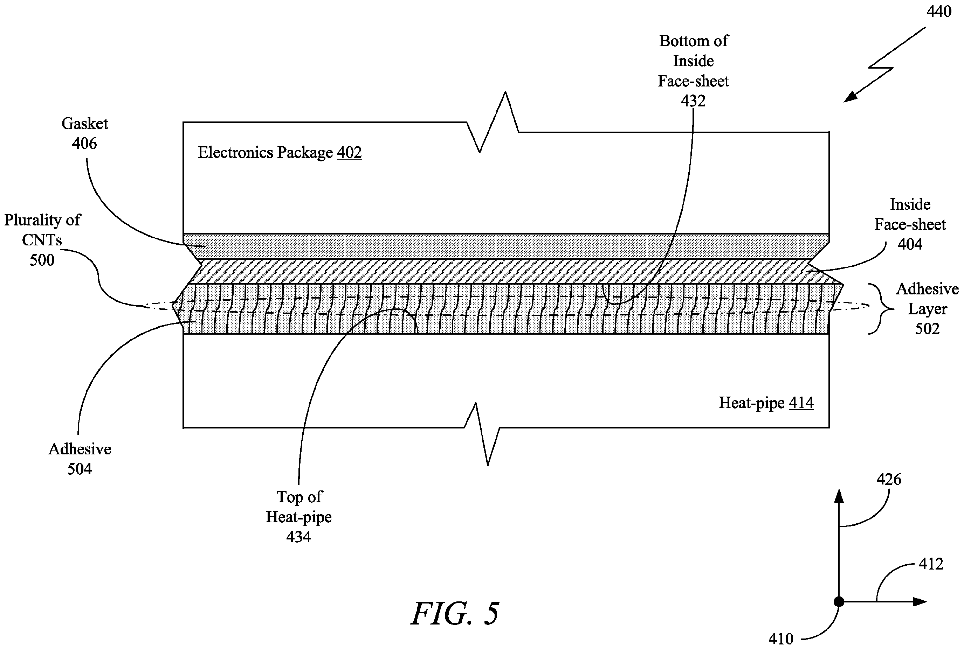

To better describe the portion 428 of the first thermal conductive joint 420, a cross-sectional view of an enlarged portion 440 of the portion 428 of the first thermal conductive joint 420 along a cutting plane looking into the front of the radiator panel 400 (i.e., the *X*-axis 410) is shown in FIG. 5 in accordance with the various embodiment.

From this enlarged portion view 440, a plurality of CNTs 500 are shown extending longitudinally (i.e., along the *Z*-axis 426) from the inside face-sheet 404 to the heat-pipe 414 through an adhesive layer 502. In this view, the adhesive layer 502 is part of the first thermal conductive joint 420 corresponding to the portion 428 of the first thermal conductive joint 420 under the gasket 406.

In this example, each CNT of the plurality of CNTs 500 may be oriented in a longitudinal direction (i.e., an axial along the length of the CNTs that correspond to the direction along the *Z*-axis 426) between the inside face-sheet 404 and the heat-pipe 414. This longitudinal direction is approximately perpendicular to the bottom 432 of the inside face-sheet 404 and top 434 of the heat-pipe 414 (i.e., along the *Z*-axis 426). Additionally, the plurality of CNTs 500 may be continuous between the inside face-sheet 404 and the heat-pipe 414 to a point where the plurality of CNTs 500 may be in physical contact with the inside face-sheet 404 and the heat-pipe 414. In this example, if the inside face-sheet 404 and heat-pipe 414 are constructed of metal, the plurality of CNTs 500 may act as a thermal bridge from the metal of inside face-sheet 404 to the metal of the heat-pipe 414. In this case, the plurality of CNTs 500 may act as a substantial thermal bridge through the adhesive layer 502. In this configuration, the plurality of CNTs 500 may form a parallel heat conduction path from the inside face-sheet 404 to the heat-pipe 414. It is appreciated by those of ordinary skill in the art that CNTs have extremely high thermal conductivity along the CNT longitudinal axis as compared to an epoxy film adhesive. In general, the thermal conductivity is improved by two to five times with the use of the CNTs.

In this example, the adhesive layer 502 may be an epoxy film disposed between the bottom surface 432 of the inside face-sheet 404 and the top surface 434 of the heat-pipe 414. As an example, the plurality of CNTs 500 and adhesive 504 in the adhesive layer 502 may be approximately 10 micrometers thick.

In an example of operation, the heat generated by the electronics package 402 is passed from the electronics package 502 through the gasket 406 and inside face-sheet 404 to the adhesive layer 502 having the adhesive 504 and the plurality of CNTs 500. The CNTs 500 in the adhesive layer 502 form a thermal bridge between the inside face-sheet 404 and heat-pipe 414 that allows a significantly higher amount of heat to be transferred from the inside face-sheet 404 to the heat-pipe 414 than the adhesive 504 in the adhesive layer 502 is capable of transferring without the presence of the plurality of CNTs 500.

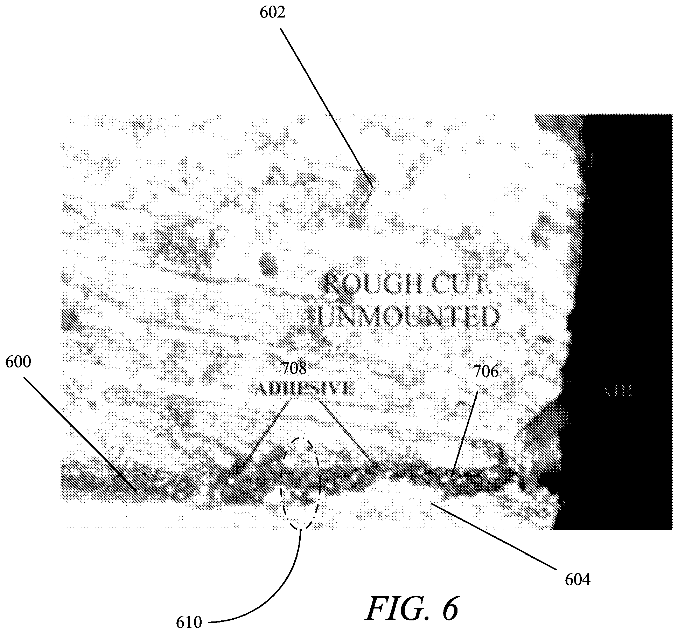

In FIG. 6, a microscopic front-view of an example of an implementation of a bond line 600 between the inside face-sheet 602 and heat-pipe 604 is shown with the plurality of CNTs 606 embedded in the adhesive layer 608 within the bond line 600 in accordance with the various embodiments.

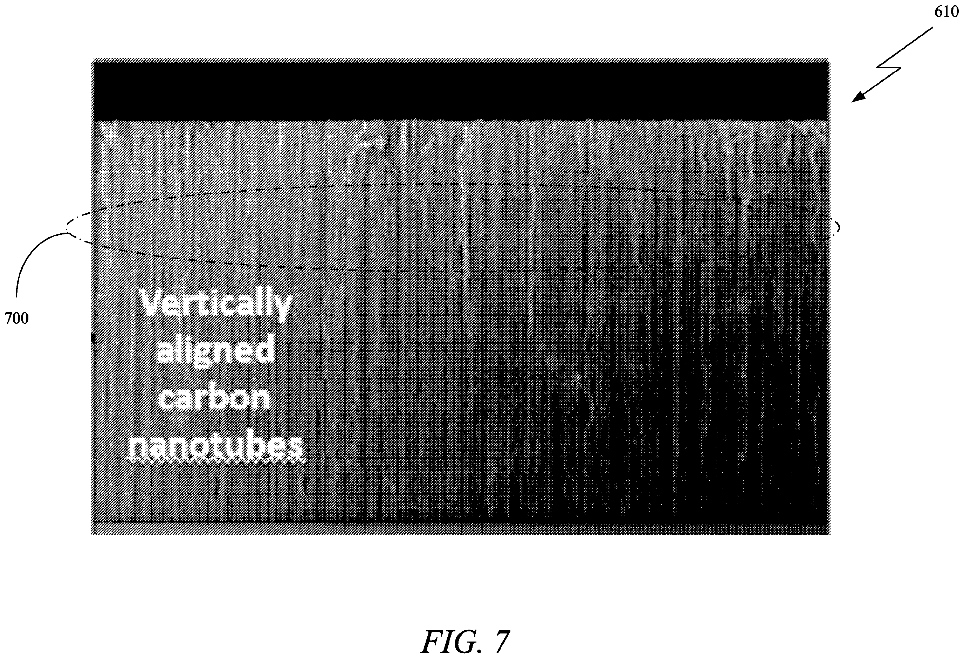

To better understand how the plurality of CNTs 600 are aligned parallel to the individual CNTs in the plurality of CNTs 600 but perpendicularly between the inside face-sheet 602 and heat-pipe 604, a cross-sectional view of an enlarged portion 610 of the adhesive layer 608 is shown in FIG. 7 in accordance with various embodiments. In FIG. 7, the plurality of CNTs 700 are shown approximately parallel and extending approximately perpendicularly between the face-sheet and heat-pipe.

It will be understood that various aspects or details of the disclosure may be changed without departing from the scope of the disclosure. It is not exhaustive and does not limit the claimed disclosures to the precise form disclosed. Furthermore, the foregoing description is for the purpose of illustration only, and not for the purpose of limitation. Modifications and variations are possible in light of the above description or may be acquired from practicing the disclosure. The claims and their equivalents define the scope of the disclosure.

## Claims

1. A thermal conductive joint (420) between a face-sheet (404) and a heat-pipe (414) in a radiator panel (400), the thermal conductive joint comprising:
an adhesive layer (502) attached between the face-sheet and the heat-pipe;
a plurality of carbon nanotubes ("CNTs") (500) within the adhesive layer;
wherein the plurality of CNTs (500) are oriented in an axial direction between the face-sheet (404) and the heat-pipe (414).

2. The thermal conductive joint (420) of claim 1, wherein the plurality of CNTs (500) are continuous between the face-sheet (404) and the heat-pipe (414).

3. The thermal conductive joint (420) of any of claims 1 to 2, wherein the plurality of CNTs (500) are in physical contact with the face-sheet (404) and heat-pipe (414) creating a thermal bridge from the face-sheet and heat-pipe.

4. The thermal conductive joint (420) of any of claims 1 to 3, wherein the plurality of CNTs (500) form parallel heat conduction paths from the face-sheet (404) to the heat-pipe (414).

5. The thermal conductive joint of any of claims 1 to 4, wherein the plurality of CNTs (500) are arranged perpendicular to an inner surface (432) of the face-sheet (404) and an inner surface of the heat-pipe (414).

6. The thermal conductive joint (420) of any of claims 1 to 5, wherein the adhesive layer (502) is an epoxy film disposed between a bottom surface (432) of the face-sheet (404) and a top surface of the heat-pipe (414).

7. The thermal conductive joint (420) of any of claims 1 to 6, wherein the heat source (402) is a traveling wave tube amplifier ("TWTA").

8. A radiator assembly (400) for a spacecraft, the radiator assembly comprising:
a face-sheet (404);
a heat-pipe (414); and
a thermally conductive joint according to any one of the preceding claims.

9. The radiator assembly of claim 8, wherein the plurality of CNTs (500) are continuous between the face-sheet (404) and the heat-pipe (414).

10. The radiator assembly of any of claims 8 to 9, wherein the plurality of CNTs (500) are in physical contact with the face-sheet (404) and the heat-pipe (414) creating a bridge from the face-sheet and the heat-pipe.

## Patentansprüche

1. Wärmeleitende Verbindung (420) zwischen einer Deckschicht (404) und einem Wärmerohr (414) in einer Kühlerplatte (400), wobei die wärmeleitende Verbindung umfasst:
eine Klebeschicht (502), die zwischen der Deckschicht und dem Wärmerohr angebracht ist;
mehrere Kohlenstoff-Nanoröhren ("CNTs") (500) innerhalb der Klebeschicht;
wobei die mehreren CNTs (500) zwischen der Deckschicht (404) und dem Wärmerohr (414) axial ausgerichtet sind.

2. Wärmeleitende Verbindung (420) nach Anspruch 1, bei der die mehreren CNTs (500) zwischen der Deckschicht (404) und dem Wärmerohr (414) durchgehend sind.

3. Wärmeleitende Verbindung (420) nach einem der Ansprüche 1 bis 2, bei der die mehreren CNTs (500) in physischem Kontakt mit der Deckschicht (404) und dem Wärmerohr (414) stehen und eine Wärmebrücke zwischen der Deckschicht und dem Wärmerohr bilden.

4. Wärmeleitende Verbindung (420) nach einem der Ansprüche 1 bis 3, bei der die mehreren CNTs (500) parallele Wärmeleitungspfade von der Deckschicht (404) zum Wärmerohr (414) bilden.

5. Wärmeleitende Verbindung nach einem der Ansprüche 1 bis 4, wobei die mehreren CNTs (500) senkrecht zu einer Innenfläche (432) der Deckschicht (404) und einer Innenfläche des Wärmerohrs (414) angeordnet sind.

6. Wärmeleitende Verbindung (420) nach einem der Ansprüche 1 bis 5, wobei die Klebeschicht (502) ein Epoxidfilm ist, der zwischen einer Unterseite (432) der Deckschicht (404) und einer Oberseite des Wärmerohrs (414) angeordnet ist.

7. Wärmeleitende Verbindung (420) nach einem der Ansprüche 1 bis 6, wobei die Wärmequelle (402) ein Wanderwellenröhrenverstärker ("TWTA") ist.

8. Kühleranordnung (400) für ein Raumfahrzeug, wobei die Kühleranordnung umfasst:
eine Deckschicht (404);
ein Wärmerohr (414); und
eine wärmeleitende Verbindung nach einem der vorhergehenden Ansprüche.

9. Kühleranordnung nach Anspruch 8, bei der die mehreren CNTs (500) zwischen der Deckschicht (404) und dem Wärmerohr (414) durchgehend sind.

10. Kühleranordnung nach einem der Ansprüche 8 bis 9, bei der die mehreren CNTs (500) in physischem Kontakt mit der Deckschicht (404) und dem Wärmerohr (414) stehen und eine Brücke zwischen der Deckschicht und dem Wärmerohr bilden.

## Revendications

1. Joint thermoconducteur (420) entre une feuille de face (404) et un tuyau de chaleur (414) dans un panneau de radiateur (400), le joint thermoconducteur comprenant :
une couche adhésive (502) fixée entre la feuille de face et le tuyau de chaleur ;
une pluralité de nanotubes de carbone (« CNT ») (500) à l'intérieur de la couche adhésive ;
dans lequel la pluralité de CNT (500) sont orientés dans une direction axiale entre la feuille de face (404) et le tuyau de chaleur (414).

2. Joint thermoconducteur (420) selon la revendication 1, dans lequel la pluralité de CNT (500) sont continus entre la feuille de face (404) et le tuyau de chaleur (414).

3. Joint thermoconducteur (420) selon l'une quelconque des revendications 1 à 2, dans lequel la pluralité de CNT (500) sont en contact physique avec la feuille de face (404) et le tuyau de chaleur (414) en créant un pont thermique par rapport à la feuille de face et au tuyau de chaleur.

4. Joint thermoconducteur (420) selon l'une quelconque des revendications 1 à 3, dans lequel la pluralité de CNT (500) forment des chemins de conduction de chaleur parallèles à partir de la feuille de face (404) vers le tuyau de chaleur (414).

5. Joint thermoconducteur selon l'une quelconque des revendications 1 à 4, dans lequel la pluralité de CNT (500) sont agencés perpendiculairement à une surface intérieure (432) de la feuille de face (404) et à une surface intérieure du tuyau de chaleur (414).

6. Joint thermoconducteur (420) selon l'une quelconque des revendications 1 à 5, dans lequel la couche adhésive (502) est un film époxy disposé entre une surface inférieure (432) de la feuille de face (404) et une surface supérieure du tuyau de chaleur (414).

7. Joint thermoconducteur (420) selon l'une quelconque des revendications 1 à 6, dans lequel la source de chaleur (402) est un amplificateur à tubes à ondes progressives (« TWTA »).

8. Ensemble de radiateur (400) pour un engin spatial, l'ensemble de radiateur comprenant :
une feuille de face (404) ;
un tuyau de chaleur (414) ; et
un joint thermoconducteur selon l'une quelconque des revendications précédentes.

9. Ensemble de radiateur selon la revendication 8, dans lequel la pluralité de CNT (500) sont continus entre la feuille de face (404) et le tuyau de chaleur (414).

10. Ensemble de radiateur selon l'une quelconque des revendications 8 à 9, dans lequel la pluralité de CNT (500) sont en contact physique avec la feuille de face (404) et le tuyau de chaleur (414) en créant un pont par rapport à la feuille de face et au tuyau de chaleur.
